# EUROPEAN PATENT SPECIFICATION

(11) **EP 0 521 615 B1**
(45) Date of publication and mention of the grant of the patent: **29.10.1997**
(21) Application number: 92305002.5
(22) Date of filing: 01.06.1992
(51) Int. Cl.: C23C 16/48, C23C 16/52

(54) **Method for forming thin film and multilayer film**
Verfahren zur Herstellung dünner Schichten und mehrlagiger Schichten
Méthode pour la formation de couches minces et de films multicouches

(30) Priority: 04.06.1991 JP 132635/91
(43) Date of publication of application: 07.01.1993
(73) Proprietor: MATSUSHITA RESEARCH INSTITUTE TOKYO, INC., Kawasaki-shi, Kanagawa-ken 214 (JP)
(72) Inventor: Yamada, Yuka, Kawasaki-shi, Kanagawa-ken 215 (JP); Mutoh, Katsuhiko, Isehara-shi, Kanagawa-ken 259-11 (JP)
(74) Representative: Warren, Keith Stanley

(56) References cited:
- US-A- 4 685 976
- PATENT ABSTRACTS OF JAPAN vol. 13, no. 262 (C-608) (3610) 16 June 1989 & JP-A-10 065 268 (HITACHI LTD.) 10 March 1989
- APPLIED PHYSICS A. SOLIDS AND SURFACES, vol.A47, no.2, October 1988, HEIDELBERG DE pages 171 - 181 L. KONSTANTINOV ET AL
- APPLIED PHYSICS A. SOLIDS AND SURFACES, vol.A47, no.3, November 1988, HEIDELBERG DE pages 271 - 284 H. SANKUR ET AL
- EXTENDED ABSTRACTS, vol.87-2, 1987, PRINCETON, NEW JERSEY US page 842 T. WADAYAMA ET AL
- PATENT ABSTRACTS OF JAPAN vol. 013, no. 394 (C-631) 31 August 1989 & JP-A-01 139 769 (TOSHIBA CORP.) 1 June 1989
- PATENT ABSTRACTS OF JAPAN vol. 012, no. 450 (C-547) 25 November 1988 & JP-A-63 176 462 (MITSUBISHI ELECTRIC CORP) 20 July 1988
- APPLIED PHYSICS A. SOLIDS AND SURFACES, vol.A47, no.2, October 1988, HEIDELBERG DE pages 171 - 181 L. KONSTANTINOV ET AL

## Description

The present invention relates to a method for forming a thin film or a multilayer film using a photo-induced CVD (chemical vapor deposition) technique which is widely used in industry.

The photo CVD technique has been used as means to form various thin films or multilayer films. The photo CVD has a problem that a film is deposited on a window through which light is introduced into a reaction chamber during film forming. The film deposited on the window decreases the intensity of the light irradiating the material gas in the reaction chamber through the window, thereby decelerating the film deposition rate onto a substrate. A conventional approach to solve this problem is blowing inert gases, such as,argon, helium, etc., onto the window as disclosed, for example, in Japanese patent laid-open No.183921/'86 or 169384/'88. Also known is a method of etching the film deposited on the window by irradiating with light of different wavelength, as disclosed in, for example, JP-A-263213/'86.

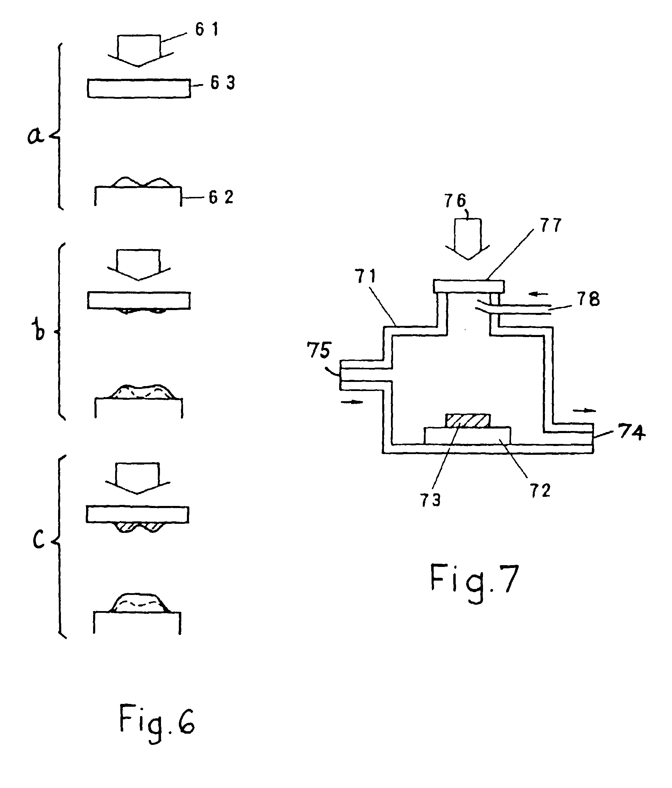

An example of the conventional technique to prevent the light introducing window from becoming clouded by blowing inert gas is described hereunder with reference to Fig. 7.

Fig.7 is a configuration diagram of a conventional thin film forming apparatus using photo CVD technique, comprising a reaction chamber 71, a substrate holder 72, a substrate 73, an evacuation orifice 74, a reactive gas intake 75, light from a light source 76, a light introducing window 77, and a purging gas intake 78.

A film forming process of the thin film forming apparatus as constructed above will be described hereunder. Firstly, the substrate 73 on which a film is formed is placed on the substrate holder 72 in the reaction chamber 71. The reaction chamber 71 is closed and evacuated through the evacuation orifice 74 to achieve high vacuum in the reaction chamber 71. The substrate 73 is then heated to a predetermined temperature before introducing a reactive gas into the reaction chamber 71 through the reactive gas intake 75. Subsequently, light 76 is irradiated through the light introducing window 77 to decompose the gas for deposition of a film on the substrate 73. Simultaneously, an inert gas is introduced through the purging gas intake 78 to prevent the reactive products from depositing on the light introducing window 77.

However, a disadvantage of the conventional system is the incomplete prevention of clouding of the light introducing window 77 due to the long time for film forming. This results in inaccurate film thickness and frequent replacement of the light introducing window. Additional disadvantages include limitation of the use of a large light introducing window for large-area film forming,higher density of the irradiation light, etc.

A modified form of photo-induced CVD is described in JP-A-10065268 on which the preamble of claim 1 is based. The apparatus described includes a deposition chamber through which light can pass completely. A light source directs light into the chamber through a first window. The light passes a film deposition area and then out of the chamber through a second window. Intensity of light issuing from the second window is detected and data dependent on its intensity is used to control the light source so as to maintain a constant intensity of light passing through the chamber regardless of clouding on the first window. The apparatus accordingly needs to constantly monitor the intensity of light passing through the chamber and constantly maintain the intensity of light emitted by the light source at the correct level.

JP-A-1-139769 discloses laser CVD apparatus wherein contamination of the incident window is monitored by means of a photodetector which detects fluorescent light emitted by the contaminant during irradiation. The window is replaced when the amount of fluorescent light detected exceeds a set value.

On the other hand, if light intensity is not uniform over the light introducing window, the thin film deposited on the window varies in thickness, i.e., thicker at the area where light intensity is higher. This acts to correct the irregularity in light intensity to be introduced in the reaction chamber. However, the thickness of the thin film to be deposited on the substrate could not be controlled to utilize the correction action when the thin film is deposited on the light introducing window in the conventional apparatus.

The present invention intends to solve the above problems of the conventional apparatus. It is, therefore, an object of the present invention to provide a method for forming a thin film or a multilayer film comprising means to correct the decrease in film deposition rate due to clouding of the light introducing window. It is another object of the present invention to provide a method for forming a thin film provided with means to correct non-uniformity in light intensity in the reaction chamber.

The present invention consists in a method for depositing a thin film by photo-induced CVD, comprising the steps of:
preparing a substrate in a reaction chamber having a light introducing window;
supplying a first material gas in said reaction chamber; and
irradiating said first material gas in the reaction chamber with light of substantially constant intensity from a light source by way of said light introducing window for decomposing said first material gas and depositing a thin film corresponding to said first material gas on said substrate;
characterised by the steps of determining in advance the relationship between the thickness of the film corresponding to said first material gas deposited on said substrate and the length of time for which the light is transmitted through said light introducing window of said reaction chamber, said relationship being partly determined by the deposition of a layer of said material on the window, and utilizing the relationship so determined to adjust the time of irradiation to give the desired film thickness on the substrate. Additionally, there may be provided means to adjust the irradiation time in a sequence-control method for simplifying the manufacturing steps.

Also, in order to form a thin film having a uniform film thickness by a photo CVD technique, there is a correction step to correct irregularity in light intensity by simultaneously forming a thin film on the light introducing window when a thin film is to be formed on the substrate in the reaction chamber.

The present invention as constructed above is able to correct poor film thickness accuracy due to clouding of the light introducing window by a simple calculation so that a desired film thickness is obtained. In this way, the light introducing window needs not to be replaced as long as sufficient light for film forming is irradiated into the reaction chamber. Also, the present invention does not limit expansion of the light introducing window for larger film forming area, increase of density of the irradiation light, etc. Additionally, the sequence control simplifies the manufacturing process.

Any non-uniformity in the light intensity can be corrected to obtain a thin film of uniform and desired film thickness.

In order that the present invention may be more readily understood, reference will now be made, by way of example, to the accompanying drawings, in which:-

Fig.1 is a schematic diagram illustrating the method of forming a thin film of the present invention.

Fig.2 is a graph illustrating light irradiation time dependency of the carbon film thickness in the first embodiment of the present invention.

Fig.3(a) is a graph illustrating light irradiation time dependency of the thicknesses of both films A and B constituting the milti-layer film in the process of calculating light irradiation time in the multilayer film forming of the present invention.

Fig.3(b) is a graph illustrating light irradiation time dependency of the light intensity to be introduced in the reaction chamber for separately forming films A and B in the process of calculating the light irradiation time for multilayer film forming of the present invention.

Fig.4(a) is a graph illustrating the result of Auger electron spectroscopy measurement of a W/C multilayer film formed in accordance with the present invention.

Fig.4(b) is a graph illustrating the result of Auger electron spectroscopy measurement of a W/C multilayer film formed using the conventional technique.

Fig.5 is a schematic diagram of thin film forming apparatus which may be used for carrying out the method of the present invention.

Fig.6 illustrates steps which may be used in the thin film forming method of the present invention.

Fig.7 is a schematic diagram of the conventional thin film forming apparatus.

Described first is the formation of a monolayer thin film using the technique of the present invention.

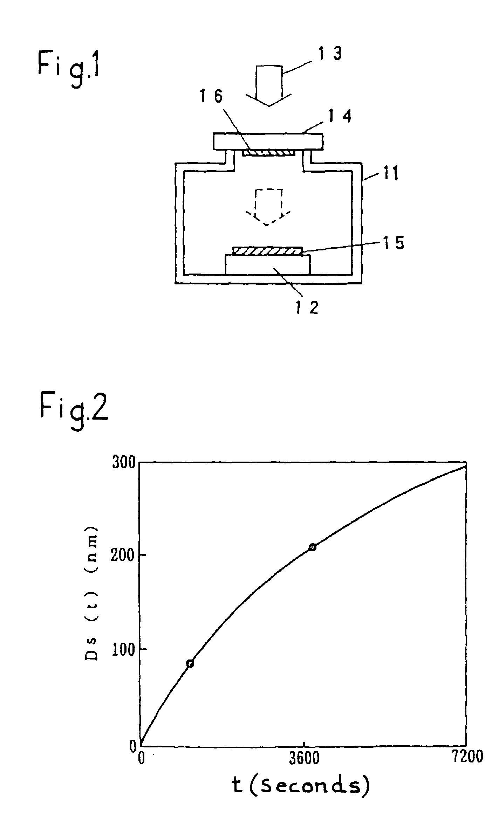

Illustrated in Fig. 1 is a schematic diagram to explain the method of forming the thin film using a photo CVD technique.In Fig.1, the reference numeral 11 is a reaction chamber, 12 is a substrate, 13 is the light from a light source, and 14 is a light introducing window. Also, the reference numeral 15 represents a thin film deposited on the substrate 12 and 16 represents a thin film deposited on the light introducing window 14.

A film forming process will be described in the thin film forming apparatus as constructed above. Firstly, the substrate 12 is placed in the reaction chamber 11 for film forming. The reaction chamber 11 is closed for evacuation to achieve high degree of vacuum. The substrate 12 is then heated to a predetermined temperature and at least a reactive gas is introduced in the reaction chamber 11. Subsequently, the light 13 from a light source is irradiated through the light introducing window 14 to decompose the gas for film deposition on the substrate 12. When the light 13 is irradiated for a certain time, deposited on the substrate 12 is a thin film 15 and simultaneously a thin film 16 on the inner surface of the light introducing window 14. A part of the light 13 is absorbed by the thin film 16, and this reduces the light intensity to excite the reactive gas in the reaction chamber 11.

The thicknesses of the films deposited on the window and the substrate are proportional to the light intensity, and proportionality factors are set to a and b. The light intensity I₀ from the light source is constant. The light introduced intensity into the reaction chamber is a function of time (t) and is given by I(t) due to clouding of the light introducing window. The film thickness Dw(t) of the thin film deposited on the light introducing window is given by the following expression: 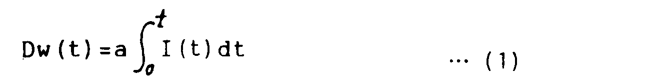 ${\text{I(t) = I}}_{\text{0}} \text{exp (-α · Dw(t))}$ where, α is the absorption coefficient of the film deposited on the window.
Also, the film thickness Ds(t) of the thin film deposited on the substrate is given by the following expression: 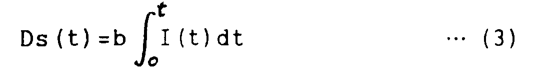 From the above expressions (1) through (3), the following are obtained:${\text{Dw(t) = ℓn(aα I}}_{\text{0}} \text{t+1)/α}$${\text{Ds(t) = (b/aα) · ℓn(aα I}}_{\text{0}} \text{t+1)}$${\text{I(t) = I}}_{\text{0}} {\text{/(aα I}}_{\text{0}} \text{t+1)}$

Accordingly, the light irradiation time dependency of Ds(t) is studied in advance to determine the factors b/aα and aα I₀ in the expression (5). In this manner, Ds(t) can be determined. This expression is used to calculate the irradiation time for a desired film thickness and the apparatus is controlled in a sequential manner.

In a first embodiment of the present invention, an irradiation time dependency of a carbon film thickness formed on a Si(silicon) substrate is studied by using an excimer-laser-induced CVD technique. A construction of the apparatus used for the carbon film forming is similar to the apparatus illustrated in Fig.7. A method of forming the thin film is also similar to the conventional method as described hereinbefore. An ArF excimer laser with a wavelength of 193 nm is used as the light source. Benzene and helium gases are used as the reactive gas and the purging gas, respectively. Fig.2 is a graph illustrating the irradiation time dependency of the carbon film thickness. Black dots represent the measured values and the solid line represents the results calculated from the expression (5) to fit the measured values, and is given by the following expression:,$\text{Ds(t) = 195·ℓn(0.000492t + 1)}$

It is to be noted that units for t and Ds(t) are are seconds and nm.

Using the above calculated values, a carbon film was first formed with a non-clouded window and then carbon films of the same film thickness were successfully formed without replacing the window but by controlling the light irradiation time. As understood from this result, the method of forming the thin film according to the present invention is effective to form thin films of desired film thickness without being affected by the degree of clouding of the window.

According to the above embodiment, in forming a thin film using photo CVD technique, thin films of desired film thickness are effectively formed by the provision of a step of sequence control to vary the light irradiation time as means to correct reduced deposition rate due to clouding of the window.

Now, an example of forming a multilayer film is described.

In addition to the steps of forming a monolayer of thin film, as described above, light irradiation time is separately controlled for each film of such multilayer film because each thin film constituting the multilayer film has different properties (deposition rate, absorption coefficient,etc). In the case of forming a multilayer film composed of alternately deposited two kinds of films, a process of calculating the light irradiation time is described hereunder by reference to the drawings.

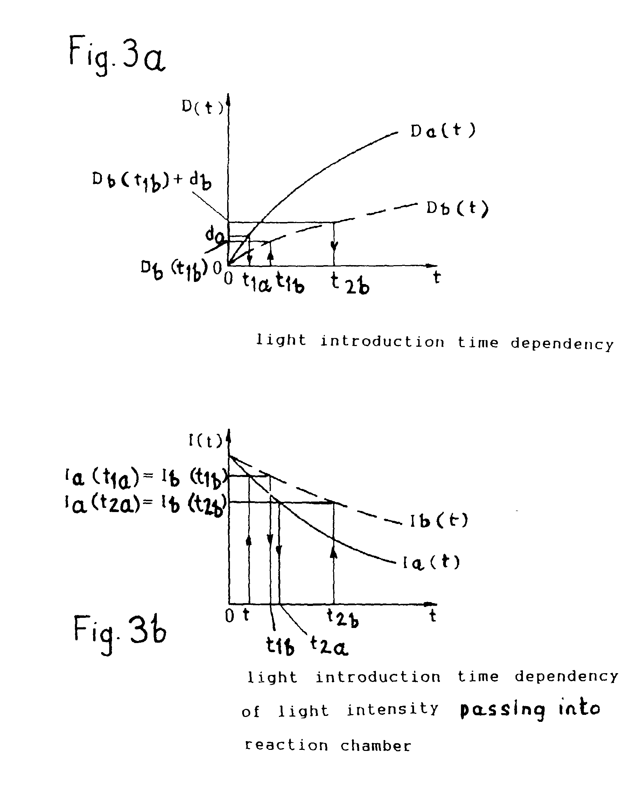

Firstly, light irradiation time dependency of the two kinds of thin films A and B constituting the multilayer film is studied prior to multilayer film forming for determining the factors in the above expression (5) for each film. As a result, it is assumed that Ds(t) for both films A and B are obtained as Dₐ(t) and D_{b}(t) as illustrated in Fig.3(a). When the films A and B are formed separately, the light intensities Iₐ (t) and I_{b} (t) introduced into the reaction chamber are given by the above expression (6) and vary as illustrated in Fig.3(b). In forming the multilayer film, the light irradiation time (t₁ₐ) required to deposit the first layer film A to a predetermined thickness (dₐ) is determined and Iₐ(t₁ₐ) at that time is also obtained. Then, the time equal in light intensity to Iₐ(t₁ₐ) for the film B, or t_{1b} to realize Iₐ(t₁ₐ)=I_{b}(t_{1b}) is calculated and also the film thickness D_{b}(t_{1b}) of the film B at this time is obtained. The light irradiation time (t_{2b}) to obtain the film thickness D_{b}(t_{1b})+d_{b} for the second layer film B of the film thickness d_{b} is calculated and the second layer film B is formed by irradiating the light for the time t_{2b}-t_{1b}. The light irradiation time is sequentially determined in the similar manner to form the multilayer film with each layer having a predetermined thickness.

In the case of forming a multilayer film composed of 3 or more kinds of films, it is understood that factors of the above expression (5) are determined for each film, and then, the light irradiation time for each layer is calculated in the same manner as the above.

In a second embodiment of the present invention, a tungsten-carbon multilayer film (referred to as W/C multilayer film below) is formed by an excimer-laser-induced CVD technique using the above calculation procedure of the irradiation time for forming the above multilayer film. The apparatus used for forming the W/C multilayer film has essentially the same construction as that in Fig.7. An ArF excimer laser is used as the light source. Tungsten hexafluoride and benzene are used as the reactive gases and helium as the purging gas. Firstly, the irradiation time dependency of the film thicknesses dw(t) and dc(t) for the tungsten and carbon films are studied in the similar manner to the first embodiment to obtain the factors as follows:$\text{dw(t) = 182·ℓn(0.000352t + 1)}$$\text{dc(t) = 195·ℓn(0.000492t + 1)}$

In either case of the above expressions, units for the time and film thickness are seconds and nm, respectively.

The irradiation time for each layer of the multilayer film was determined by the above calculation procedure using the expression (8) and (9), and the multilayer film was formed using this result.

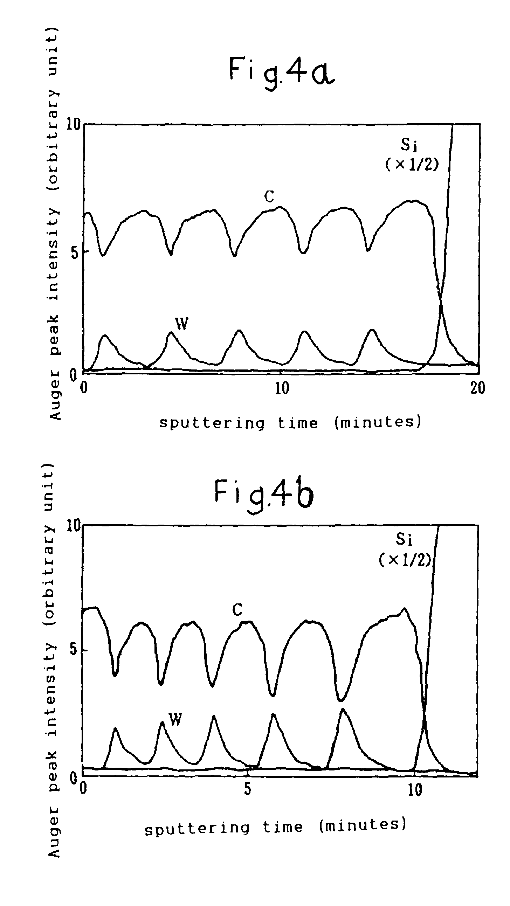

Fig.4(a) shows the result from an Auger electron spectroscopy measurement of the W/C multilayer film in the second embodiment of the present invention. Fig.4(b) shows the result from an Auger electron spectroscopy measurement of the W/C multilayer film with each layer formed by irradiating the light for a constant time using the same apparatus. The horizontal axis represents the sputtering time which is proportional to the film thickness. In the drawings, Si represents the substrate on which C (carbon) and W (tungsten) films are formed alternately. As apparent from Fig.4(b) of the conventional technique, the film thickness decreases with an increase in the layer number. For example, the thickness of the fifth C layer is about 60% of that of the first C layer. On the other hand, in Fig.4(a) for the multilayer film formed in accordance with the second embodiment of the present invention, the thickness of the first through fifth layers are essentially the same.

It is now obvious from the above description that sequence control of the light irradiation time for thin film constituting the multilayer film enables accurate control of each layer thickness.

Although the excimer-laser-induced CVD technique is used in the first and second embodiments, it is understood that other light sources, such as, a low pressure mercury lamp and the like, may be used as the light source. Also, the present invention is effective to form thin films and multilayer thin films other than carbon films, tungsten films and W/C multilayer films.

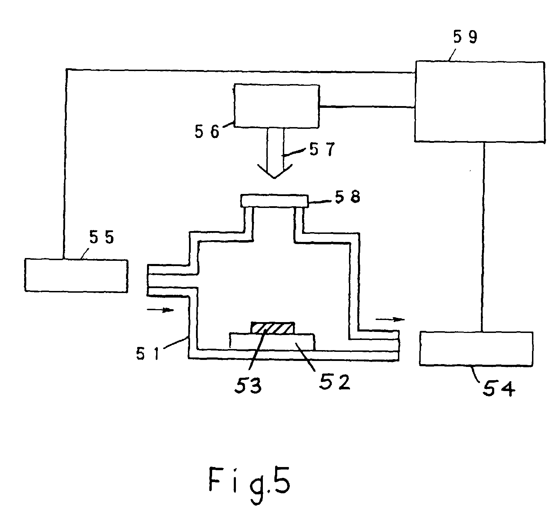

A thin film forming apparatus including means to control the light irradiation time in the first and second embodiments may be constructed, for example, as shown in Fig.5. In Fig.5, represented by reference numerals 51, 52, 53, 54, 55, 56, 57, 58 and 59 are a reaction chamber, a substrate holder, a substrate, an evacuation system, a gas intake system, a light source, a light beam from the light source 56, a light introducing window, and a light irradiation time control system, respectively.

A thin film forming process will be described hereunder by reference to the above thin film forming apparatus. The substrate 53 on which a film is formed is first placed on the substrate holder 52 in the reaction chamber 51. The reaction chamber 51 is closed and evacuated by the evacuation system 54 to achieve high degree of vacuum within the reaction chamber 51. The substrate 53 is, then, heated to a predetermined temperature before introducing the reactive gas into the reaction chamber 51 from the gas intake system 55. Subsequently, the light beam 57 from the light source 56 is irradiated through the light introducing window 58 to decompose the gas for deposition of a thin film on the substrate 53. The series of operations are controlled by the light irradiation time control system 59 to form a thin film of a desired thickness.

Finally, studied is non-uniformity in light intensity passing through the light introducing window.

If there is any non-uniformity in light intensity, the deposited film tends to be thicker at the higher intensity portion of the light. However, the thin film to be deposited on the light introducing window will be thicker at that portion, thereby decreasing the light intensity passing through the window because more light is absorbed in the thin film. This acts to deposit a uniform thin film on the substrate. It is therefore possible to correct non-uniformity in light intensity and form a uniform thin film of desired film thickness by controlling the ratio of film thickness of the thin films deposited on the substrate and the light introducing window and also the light irradiation time.

Fig.6 shows steps which may be used in the method of forming a thin film according to the present invention. In Fig.6, represented by the reference numerals 61, 62, and 63 are a light beam, a substrate and a light introducing window. The light beam 61 is non-uniform in this particular instance. In the above construction, when the non-uniform light 61 is irradiated, a thin film is deposited on the substrate 62 (Fig.6(a)). It is to be noted here that thicker film is deposited at higher intensity portion of the light 61, thereby causing a non-uniform thin film as shown in the Figure. However, the continued irradiation of the light 61 will lead to the deposit of a similarly non-uniform thin film on the light introducing window 63, thereby absorbing the light to decrease the light intensity passing through the window. This affects more at the portion where the thicker film is deposited, i.e., at the higher intensity portion of the light from the light source. Accordingly, the thin film on the window helps to correct the non-uniformity of the thin film to be deposited on the substrate (Fig.6(b)). Continued irradiation of the light will lead to the deposit of a thin film of uniform film thickness on the substrate (Fig.6(c)).

It is now understood that optimizing the ratio of thickness of the thin films to be deposited on the substrate and the light introducing window will be effective in depositing a uniform thin film on the substrate.

## Claims

1. A method for depositing a thin film by photo-induced CVD, comprising the steps of:
preparing a substrate (53) in a reaction chamber (51) having a light introducing window (58);
supplying a first material gas in said reaction chamber; and
irradiating said first material gas in the reaction chamber with light (57) of substantially constant intensity from a light source (56) by way of said light introducing window (58) for decomposing said first material gas and depositing a thin film corresponding to said first material gas on said substrate;
characterised by the steps of determining in advance the relationship between the thickness of the film corresponding to said first material gas deposited on said substrate and the length of time for which the light is transmitted through said light introducing window of said reaction chamber, said relationship being partly determined by the deposition of a layer of said material on the window (58), and utilizing the relationship so determined to adjust the time of irradiation to give the desired film thickness on the substrate.

2. A method according to claim 1, wherein the irradiation time is calculated as a logarithmic function of the desired film thickness.

3. A method according to claim 1 or claim 2, further comprising the steps of:
supplying a second material gas in said reaction chamber (51) subsequent to said first thin film forming step; and
a second thin film forming step of irradiating the second material gas with light (57) of substantially constant intensity from a light source (56) by way of said light introducing window (58) of said reaction chamber for decomposing said second material gas and depositing a thin film corresponding to said second material gas on said substrate;
wherein the irradiation time for the second film forming step is also set according to a predetermined relationship between the irradiation time and the deposited film thickness of material deposited from the second material gas.

4. A method according to claim 3, wherein the irradiation in said second thin film forming step is calculated as a logarithmic function of the desired thickness for the second film.

## Patentansprüche

1. Verfahren zum Niederschlagen eines Dünnfilms durch ein fotoinduziertes CVD-Verfahren, mit den Verfahrensschritten:
Vorbereiten eines Substrates (53) in einer Reaktionskammer (51), die ein Lichteinlaßfenster (58) hat,
ein Gas aus einem ersten Stoff in die Reaktionskammer zu leiten, und
Bestrahlen des Gases aus dem ersten Stoff in der Reaktionskammer mit Licht (57) von im wesentlichen konstanter Intensität aus einer Lichtquelle (56) durch das Lichteinlaßfenster (58), um das Gas aus dem ersten Stoff zu zerlegen und auf dem Substrat einen Dünnfilm niederzuschlagen, der dem Gas aus dem ersten Stoff entspricht,
gekennzeichnet durch die Verfahrensschritte, im voraus die Beziehung zwischen der Dicke des auf dem Substrat niedergeschlagenen Films, der dem Gas aus dem ersten Stoff entspricht, und der Zeitspanne zu ermitteln, während der das Licht durch das Lichteinlaßfenster der Reaktionskammer durchgelassen wird, wobei die Beziehung teilweise durch das Niederschlagen einer Schicht aus dem Stoff auf dem Fenster (58) ermittelt wird und die so ermittelte Beziehung zur Einstellung der Bestrahlungszeit verwendet wird, die die gewünschte Filmdicke auf dem Substrat liefert.

2. Verfahren gemäß Anspruch 1, wobei die Bestrahlungszeit als eine logarithmische Funktion der gewünschten Filmdicke berechnet wird.

3. Verfahren gemäß Anspruch 1 oder Anspruch 2, das weiterhin folgende Verfahrensschritte umfaßt:
im Anschluß an den ersten Verfahrensschritt zur Erzeugung eines Dünnfilms ein Gas aus einem zweiten Stoff in die Reaktionskammer (51) zu leiten, und
einen zweiten Verfahrensschritt zur Erzeugung eines Dünnfilms durch Bestrahlen des Gases aus dem zweiten Stoff mit Licht (57) von im wesentlichen konstanter Intensität aus einer Lichtquelle (56) durch das Lichteinlaßfenster (58) der Reaktionskammer, um das Gas aus dem zweiten Stoff zu zerlegen und auf dem Substrat einen Dünnfilm niederzuschlagen, der dem Gas aus dem zweiten Stoff entspricht,
wobei die Bestrahlungszeit für den zweiten Verfahrensschritt zur Erzeugung eines Films außerdem in Übereinstimmung mit einer vorgegebenen Beziehung zwischen der Bestrahlungszeit und der niedergeschlagenen Filmdicke des aus dem Gas aus dem zweiten Stoff niedergeschlagenen Stoffes eingestellt wird.

4. Verfahren gemäß Anspruch 3, wobei die Bestrahlung in dem zweiten Verfahrensschritt zur Erzeugung eines Dünnfilms als eine logarithmische Funktion der gewünschten Dicke für den zweiten Film berechnet wird.

## Revendications

1. Procédé permettant de déposer une couche mince grâce à une CVD par photoinduction, comprenant les étapes suivantes :
préparation d'un substrat (53) dans une chambre de réaction (51) présentant une fenêtre d'introduction de la lumière (58) ;
fourniture d'un premier gaz matière dans ladite chambre de réaction ; et
irradiation dudit premier gaz matière dans la chambre de réaction avec de la lumière (57) d'une intensité sensiblement constante provenant d'une source lumineuse (56) par le biais de ladite fenêtre d'introduction de la lumière (58) afin de décomposer ledit premier gaz matière et de déposer une couche mince correspondant audit premier gaz matière sur ledit substrat ;
caractérisé par les étapes consistant à déterminer à l'avance la relation entre l'épaisseur de la couche correspondant audit premier gaz matière déposé sur ledit substrat et la durée pendant laquelle la lumière est transmise à travers ladite fenêtre d'introduction de la lumière de ladite chambre de réaction, ladite relation étant partiellement déterminée par le dépôt d'une couche de ladite matière sur la fenêtre (58), et à utiliser la relation ainsi déterminée pour régler la durée d'irradiation afin de donner l'épaisseur de couche désirée sur le substrat.

2. Procédé selon la revendication 1, dans lequel la durée d'irradiation est calculé sous la forme d'une fonction logarithmique de l'épaisseur de couche désirée.

3. Procédé selon la revendication 1 ou la revendication 2, comprenant en outre les étapes suivantes :
fourniture d'un second gaz matière dans ladite chambre de réaction (51) après l'étape de formation de ladite première couche mince ; et
étape de formation d'une seconde couche mince d'irradiation du second gaz matière avec de la lumière (57) d'intensité sensiblement constante provenant d'une source lumineuse (56) par le biais de ladite fenêtre d'introduction de la lumière (58) de ladite chambre de réaction afin de décomposer ledit second gaz matière et de déposer une couche mince correspondant audit second gaz matière sur ledit substrat ;
dans lequel la durée de l'irradiation au cours de l'étape de formation de la seconde couche est également fixée selon une relation prédéterminée entre la durée de l'irradiation et l'épaisseur de la couche déposée de matière déposée à partir du second gaz matière.

4. Procédé selon la revendication 3, dans lequel l'irradiation au cours de ladite étape de formation de la seconde couche mince est calculée sous la forme d'une fonction logarithmique de l'épaisseur désirée pour la seconde couche.
